# EUROPÄISCHE PATENTSCHRIFT

(11) **EP 3 257 071 B1**
(45) Veröffentlichungstag und Bekanntmachung des Hinweises auf die Patenterteilung: **13.06.2018**
(21) Anmeldenummer: 15793737.6
(22) Anmeldetag: 03.11.2015
(51) Int. Cl.: H01L 21/67, B26F 3/00

(54) **VORRICHTUNG UND VERFAHREN ZUM ZUMINDEST TEILWEISEN LÖSEN EINER VERBINDUNGSSCHICHT EINES TEMPORÄR VERBONDETEN SUBSTRATSTAPELS**
APPARATUS AND METHOD FOR AT LEAST PARTIALLY DISSOLVING A COMPOUND LAYER OF A TEMPORARILY BONDED SUBSTRATE STACK
DISPOSITIF ET PROCEDE DE AU MOINS PARTIELLE DISSOLUTION D'UNE COUCHE D'UN COMPOSÉ D'UN EMPILEMENT DE SUBSTRAT TEMPORAIRE LIÉ

(30) Priorität: 10.02.2015 DE 102015101897
(43) Veröffentlichungstag der Anmeldung: 20.12.2017
(73) Patentinhaber: Ev Group E. Thallner GmbH, 4782 St. Florian am Inn (AT)
(72) Erfinder: FEHKÜHRER, Andreas, 4973 Senftenbach (AT)
(74) Vertreter: Schneider, Sascha
(86) Internationale Anmeldenummer: PCT/EP2015/075585
(87) Internationale Veröffentlichungsnummer: WO 2016/128079

(56) Entgegenhaltungen:
- KR-B1- 100 791 995
- US-A1- 2002 029 849
- US-A1- 2003 003 687
- US-A1- 2008 047 589

## Beschreibung

Das Rückdünnen von Produktsubstraten ist in der Halbleiterindustrie häufig erforderlich und kann mechanisch und/oder chemisch erfolgen. Zum Rückdünnen werden die Produktsubstrate in der Regel auf einem Träger vorübergehend fixiert.

Es sind verschiedene Verfahren zur Auflösung oder Zerstörung der Verbindungsschicht bekannt, wie beispielsweise die Verwendung von UV-Licht, Laserstrahlen oder Temperatureinwirkung. Andere Ansätze verfolgten eine Trennung durch Lösungsmittel. Die Druckschrift US 2003/003687 A1 offenbart eine Vorrichtung mit mehreren Düsen, mit der nur ein einzelner Substratstapel bearbeitet werden kann. Als weiterer Stand der Technik werden noch die KR 100791995 B1, US 2002/029849 A1 und US 2008/047589 A1 genannt.

Das Ablösen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden.

Darüber hinaus haben die dünnen Substrate kaum bis keine Formstabilität und rollen sich typischerweise ohne Stützmaterial ein. Während der Handhabung der rückgedünnten Substrate ist mithin eine Fixierung und Unterstützung der Substrate praktisch unumgänglich.

Es ist die Aufgabe der vorliegenden Erfindung eine verbesserte Vorrichtung bzw. ein verbessertes Verfahren zum zumindest teilweisen Lösen einer Verbindungsschicht eines temporär verbondeten Substratstapels zur Verfügung zu stellen.

Diese Aufgabe wird mit der erfindungsgemäßen Vorrichtung bzw. mit dem erfindungsgemäßen Verfahren gemäß den nebengeordneten Ansprüchen gelöst. Die vorliegende Erfindung bezieht sich auf eine Vorrichtung nach dem unabhängigen Vorrichtungsanspruch 1 und auf ein Verfahren nach dem unabhängigen Verfahrensanspruch 16. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Die Vorrichtung weist erfindungsgemäß mehrere Ringe auf, wobei der Substratstapel innerhalb der Ringe platzierbar ist, wobei der Ring eine Mehrzahl von Düsen aufweist, wobei die Düsen zumindest über einen Teil des Umfangs des Rings verteilt angeordnet sind, wobei die Düsen auf die Verbindungsschicht ausgerichtet sind, wobei die Vorrichtung derart ausgebildet ist, dass Lösungsmittel aus den Düsen auf einen Randbereich der Verbindungsschicht spritzbar ist.

Durch die ringförmig angeordneten Düsen ist vorteilhaft ein gleichmäßiges Auflösen zumindest eines Teils der Verbindungsschicht möglich. Dadurch kann vorteilhaft erreicht werden, dass die Trennung des Substratstapels relativ schonend und schnell erfolgen kann. Mit Vorteil wird die Verbindungsschicht lediglich teilweise gelöst, das heißt nur angelöst, so dass der Substratstapel noch ausreichend fest verbunden bleibt, so dass er ohne beschädigt zu werden einer anderen Bearbeitungsstation zugeführt werden kann. So kann insbesondere erreicht werden, dass die Verbindungsschicht in einem ersten Schritt lediglich angelöst wird und in einem darauf folgenden zweiten Schritt erst vollständig aufgelöst wird. Dadurch kann das Trennen des Substratstapels noch schonender und noch schneller erfolgen. Außerdem kann die Halterung des Substratstapels vereinfacht werden, da nur eine Seite des Substratstapels festgehalten werden muss. Durch diese einfache Halterung kann der Aufbau der Vorrichtung erheblich vereinfacht werden, so dass es möglich ist, mehrere Substratstapel gleichzeitig zu bearbeiten. Weiterhin kann durch den einfachen Aufbau der Halterung außerdem eine Reinigung des Substratstapels in der Vorrichtung erfolgen.

Es ist jedoch grundsätzlich mit der vorliegenden Erfindung auch möglich, die Verbindungsschicht in einem Arbeitsgang vollständig aufzulösen und den Substratstapel komplett zu trennen.

Die Erfindung weist insbesondere die folgenden Vorteile auf:
- es können mehrere Substratstapel gleichzeitig bearbeitet werden
- die Bearbeitungszeiten verringern sich
- es sind keine rotierenden Teile erforderlich
- vergleichsweise einfacher Aufbau
- auch die Substratstapelträger bzw. -Halterungen können gereinigt werden

Die erfindungsgemäße Vorrichtung und das Verfahren eignen sich insbesondere zur Lösung, insbesondere Anlösung, von Substratstapeln, die nur partiell, mit Vorzug nur peripher in ihrem Randbereich, verbondet sind. Mit besonderem Vorzug werden die erfindungsgemäße Vorrichtung und das erfindungsgemäße Verfahren zur Anlösung zweier Substrate, die nur bereichsweise, insbesondere mit einem ZoneBond® Prozess, miteinander temporär verbondet wurden, verwendet.

Der Substratstapel weist mindestens zwei Substrate auf, die über die Verbindungsschicht, zumindest bereichsweise, temporär miteinander verbondet sind. Bei den beiden Substraten kann es sich um einen Träger, insbesondere um einen Halbleiterwafer, und ein Produktsubstrat, insbesondere um einen Halbleiterwafer, handeln. Der Substratstapel kann auch aus drei oder mehr Substraten und/oder aus mehreren Schichten bestehen, insbesondere ein 3-Wafer-Stack (Triple Stack) sein.

Das Produktsubstrat ist insbesondere auf eine Dicke zwischen 0,5 µm und 250 µm gedünnt. Als Träger wird bevorzugt ein Trägersubstrat mit einer Dicke zwischen 50 µm und 5000 µm, besonders bevorzugt zwischen 500 µm und 1000 µm verwendet.

Die Substrate können jede beliebige Form besitzen, insbesondere eine runde Form. Der Durchmesser der Substrate ist insbesondere industriell genormt. Für Wafer sind die industrieüblichen Durchmesser 1 Zoll, 2 Zoll, 3 Zoll, 4 Zoll, 5 Zoll, 6 Zoll, 8 Zoll, 12 Zoll und 18 Zoll.

Für die Verbindungsschicht kommt eine Folie oder ein Kleber, insbesondere ein lösbarer Kleber, bevorzugt ein Thermoplast, in Frage, der insbesondere selektiv in einem Randbereich des Trägersubstrat-Produktsubstrat-Verbundes, mit Vorzug in einer Randzone von 0,1 mm bis 20,0 mm Breite, besonders bevorzugt von 0,1 bis 10,0 mm, mit größerem Vorzug von 0,1 bis 5,0 mm, mit größtem Vorzug von 0,1 bis 2,0 mm, mit allergrößtem Vorzug von 0,1 bis 1,0 mm Breite aufgebracht wird. Alternativ kann der Kleber insbesondere vollflächig aufgebracht werden, wobei die Klebekraft bevorzugt im Zentrum durch eine haftreduzierende Schicht, insbesondere ein Fluorpolymer, vorzugsweise Teflon, reduziert sein kann.

Die, insbesondere chemische, Anlösung der Verbindungsschicht ist für das Produktsubstrat besonders schonend und die Anlösung kann sehr schnell erfolgen, insbesondere wenn nur Randbereiche des Produktsubstrats mit einer Verbindungsschicht versehen sind, so dass das Lösungsmittel insbesondere von der Seite her schnell wirken kann. In einer bevorzugten erfindungsgemäßen Ausführungsform wird ein Anlösen am Rand erreicht, sodass die Trennung bzw. das Ablösen rasch und ohne Einwirkung starker Kräfte unmittelbar danach insbesondere in einer separaten Station durchgeführt werden kann. Die vollständige Ablösung erfolgt insbesondere durch die Kombination von chemischem Lösen (Auflösen) und mechanischer Einwirkung.

Die Vorrichtung bzw. das Verfahren kann insbesondere zum Anlösen, Ablösen und/oder Reinigen des Substratstapels bzw. des Produktsubstrats ausgebildet sein. Die Vorrichtung kann modulartig ausgebildet und insbesondere Teil einer Gesamtanlage sein. Die Vorrichtung kann aber auch selbst eine Gesamtanlage mit mehreren Modulen zum Beispiel Anlösemodul, Ablösemodul und/oder Reinigungsmodul sein. Die Module können clusterförmig und/oder sternförmig um ein Zentralmodul herum, insbesondere mit einer Bewegungseinrichtung für die Substrate bzw. Substratstapel (zum Beispiel einem Robotersystem), angeordnet werden.

Der Erfindung liegt insbesondere der Gedanke zugrunde, das Produktsubstrat schonend vom Trägersubstrat anzulösen und zwar insbesondere für mehrere Substratstapel gleichzeitig. Es ist insbesondere vorgesehen, dass die Anlösung der Verbindungsschicht, bevorzugt in konzentrischen Bahnen, insbesondere Kreisen, vom Umfang der Verbindungsschicht zum Zentrum der Verbindungsschicht erfolgt. Die Erfindung betrifft insbesondere eine Vorrichtung und ein Verfahren zum schnellen Anlösen von mehreren Substratstapeln gleichzeitig. Die Prozesszeit wird durch die Düsen (Düsen umfassen auch Schlitze und Bohrungen), die insbesondere direkt auf die Verbindungsschicht (bzw. in das Bondinterface) sprühen, reduziert. Insbesondere wird bei diesem Prozess der Substratstapel nicht rotiert, insbesondere bleibt der Substratstapel während des Lösens der Verbindungsschicht unbewegt. Ein besonderer erfindungsgemäßer Vorteil besteht darin, dass kontinuierlich frisches oder zumindest wieder aufbereitetes Lösungsmittel zum Lösen der Verbindungsschicht verwendet wird. Damit wird eine neue und erfindungsgemäße Vorrichtung zum Lösen der Verbindungsschicht offenbart, die sich eindeutig von Vorrichtungen unterschiedet, in denen der Substratstapel vollständig von Lösungsmittel umgeben wird, welches im Laufe der Zeit durch die Komponenten der Verbindungsschicht verunreinigt wird.

Erfindungsgemäß weist die Vorrichtung mehrere Ringe auf. Der Ring ist mit Vorzug in 0,1 bis 15 mm, mit größerem Vorzug in 0,1 bis 10 mm, mit größtem Vorzug in 0,1 bis 8 mm, mit allergrößtem Vorzug in 0,1 bis 5 mm Abstand zum Substratstapel und/oder zur Verbindungsschicht angebracht. Dadurch ist ein besonders effizientes Lösen bzw. Anlösen der Verbindungsschicht möglich.

Der Ring ist insbesondere mit einer Lösungsmittelleitung ausgestattet, die zu der Mehrzahl an Düsen führt. Die Düsen sind bevorzugt über den gesamten Umfang, insbesondere gleichmäßig voneinander beabstandet, des Ringes verteilt angeordnet. Dadurch ist vorteilhaft ein besonders gleichmäßiges Lösen bzw. Anlösen der Verbindungsschicht möglich.

Der Ring weist bevorzugt mindestens 60, mit größerem Vorzug mehr als 70, mit größerem Vorzug mehr als 80, mit noch größerem Vorzug mehr als 100, mit ganz besonderem Vorzug mehr als 120 Düsen, insbesondere am ganzen Umfang des Ringes, auf.

Es ist bevorzugt vorgesehen, dass die Düsen einen Durchmesser von 0,01 bis 10 mm, mit Vorzug von 0,01 bis 7 mm, mit größerem Vorzug von 0,01 bis 5 mm, mit größtem Vorzug von 0,1 bis 2 mm aufweisen. Dadurch ist vorteilhaft ein besonders effizientes Lösen bzw. Anlösen der Verbindungsschicht möglich.

Der Querschnitt und/oder die Form der Düsen können variieren und die Düsenströmung ist insbesondere abhängig von der Bauform der Düsen. Insbesondere durch, bevorzugt in der Horizontalebene, schwenkbare Düsen bzw. Düsenhalterungen kann ein gleichmäßiges, und insbesondere vollständiges, Bespritzen der Verbindungsschicht erreicht werden. Der Schwenkungsgrad der Düsen bzw. der Düsenhalterungen beträgt insbesondere 1° bis 20°, bevorzugt 1° bis 15°.

In einer nicht erfindungsgemäßen Ausführungsform weist der Ring genau eine Düse auf. Dadurch wird die Verbindungsschicht lediglich örtlich begrenzt angelöst. Insbesondere durch eine, bevorzugt in der Horizontalebene, schwenkbare Düse bzw. Düsenhalterung kann ein gleichmäßiges Bespritzen der Verbindungsschicht im örtlich begrenzten Winkelbereich der Düse erreicht werden. Die dadurch angelöste Stelle dient als Sollbruchstelle für die (u.a. mechanische) Trennung bzw. für das Ablösen von Produktsubstrat vom Trägersubstrat, insbesondere in einer separaten Station.

Die Düsen können radial bewegt werden. Insbesondere könne die Düsen bis an die Peripherie der Substrate, insbesondere die Verbindungsschicht bewegt werden und diese, falls nötig, sogar kontaktieren. Eine Kontaktierung ist aber auf Grund des Verschmutzungsrisikos der Düse durch die Komponenten der Verbindungsschicht nicht erwünscht. Der maximale Verfahrweg einer Düse ist dabei größer als 0 mm, vorzugsweise größer als 0.5 mm, noch bevorzugter mehr als 1 mm, am bevorzugtesten mehr als 5 mm, am allerbevorzugtesten mehr als 10 mm.

Um den Substratstapel in der (An-)Löseposition innerhalb des Ringes zu halten, ist der mindestens eine Ring bevorzugt mit mindestens einer, insbesondere schwenkbaren, Halterung, insbesondere mit mindestens einem Fixierungspin zum Befestigen des Substratstapels, ausgestattet. Dadurch ist vorteilhaft eine verbesserte Befestigung des Substratstapels möglich. In einer weiteren beispielhaften Ausführung ist eine Vakuumeinrichtung auf der Halterung angeordnet.

Mehrere Ringe, insbesondere mit den korrespondierenden Halterungen, können, insbesondere vertikal, übereinander, insbesondere gestapelt, angeordnet werden und können insbesondere in einer geschlossenen Kammer untergebracht werden. Die übereinander angeordneten Ringe sind insbesondere miteinander verbunden und werden, insbesondere mittels Verbindungs- bzw. Versorgungsleitungen, mit Lösungsmittel, insbesondere mittels einer, insbesondere leistungsstarken, Umwälzpumpe, versorgt.

Mit Vorzug können 2 bis 30 Ringe, mit größerem Vorzug 2 bis 15, mit größtem Vorzug 2 bis 10, mit allergrößtem Vorzug 2 bis 5 Ringe übereinander angeordnet werden, sodass vorteilhaft mehrere Substratstapel, insbesondere gleichzeitig, behandelt werden können.

Die vorliegende Erfindung ermöglicht insbesondere durch den Ring und das Lösungsmittelleitungssystem (im Folgenden auch Common Rail System genannt) ein gleichmäßiges Besprühen, insbesondere vom gesamten Verbindungsschichtumfang, ohne den Substratstapel und/oder den Ring drehen zu müssen. In einer alternativen Ausführungsform sind der Ring bzw. die Ringe und/oder die Halterungen beweglich, insbesondere drehbar, ausgebildet. Zur Halterung und Transport von Substraten wie z.B. Wafer bzw. Substratstapel werden diese auf eine Aufnahmeeinrichtung aufgebracht. Als Aufnahmeeinrichtung eignet sich insbesondere ein Probenhalter (engl.: chuck). Um ein vollständiges und/oder schnelleres Lösen bzw. Anlösen zu ermöglichen, wird eine Rotation von Substrat und/oder Düse i.e. Ring durchgeführt. Dabei erfolgt eine Relativrotation zwischen den Düsen und dem Substratstapel. Mit Vorzug befindet sich der Substratstapelhalter auf einer Welle, welche um Ihre Achse in Rotation versetzt werden kann. Anstatt der Drehung ist auch eine Oszillation des Substratstapelhalters um die Welle möglich. Dabei kann eine Drehung bzw. Oszillation so eingestellt werden, dass durch die Oszillation zumindest jener Winkel, der zwischen zwei Düsen liegt, abgedeckt wird. Dadurch wird der gesamte Verbindungsschichtumfang abgedeckt und es können weniger Düsen eingesetzt werden.

Durch die erfindungsgemäße Vorrichtung und das erfindungsgemäße Verfahren ist es insbesondere möglich, mehrere Substratstapel nacheinander in die übereinander angeordneten, insbesondere gestapelten, Ringe der Vorrichtung zu laden, um dann gleichzeitig die Randzonen zu lösen bzw. zumindest anzulösen (z.B. in einem Edge Zone Release Prozess-Schritt).

Besonders bevorzugt weist die Vorrichtung eine einschwenkbare Abschirmung auf, sodass, wenn das Lösen bzw. Anlösen beendet ist und der unterste Substratstapel zur Reinigung entnommen wird, die Abschirmung die Verunreinigung vom untersten Substratstapel durch Tropfen von oben verhindert. Ist die Abschirmung eingeschwenkt, kann der Substratstapel gereinigt und dann getrocknet werden. Zum Holen des nächsten Substratstapels geht die Abschirmung wieder auf. Die Abschirmung dient als Tropfschutz- bzw. Spritzschutzvorrichtung und wird manuell, automatisch und/oder halbautomatisch gesteuert. Die Abschirmung kann z.B. mittels eines Aktuators von der eingeschwenkten, schützenden Position in eine Ausgangsposition (nicht dargestellt) gebracht werden. Die darauf fallenden Tropfen werden z.B. über eine Schräge abgeführt. Die Abschirmung kann jede Form haben, mit Vorzug rund, rechteckig oder quadratisch. Die Abschirmung erstreckt sich über die Ringe der Vorrichtung bzw. schließt mit einer Abdichtung ab, sodass es zu keiner Verunreinigung durch Tropfen von oben kommen kann.

Bevorzugt weist die Vorrichtung eine, insbesondere in vertikaler Richtung, bewegliche Aufnahmeeinrichtung zur Aufnahme des Substratstapels auf. Die Aufnahmeeinrichtung dient dem Transport des Substratstapels. Die Aufnahmeeinrichtung transportiert den Substratstapel zum Ring hin und/oder vom Ring weg. Die Aufnahmeeinrichtung dient somit zum Laden und/oder Entladen des Ringes. Vorteilhaft kann der Substratstapel auf der Aufnahmeeinrichtung fixiert werden. Als Aufnahmeeinrichtung eignet sich insbesondere ein Probenhalter (engl.: chuck). Die Aufnahmeeinrichtung bringt bevorzugt einzelne Substratstapel in die (An-)Löseposition bzw. (An-)Lösepositionen. In einer vorteilhaften Ausführung der Erfindung ist vorgesehen, dass die Aufnahmeeinrichtung bzw. die Vorrichtung Ladestifte aufweist, die den Substratstapel auf der Halterung absetzen bzw. von der Halterung aufnehmen.

Vorteilshalber ist bevorzugt vorgesehen, den untersten Substratstapel mit der, insbesondere in z-Richtung, beweglichen Aufnahmeeinrichtung soweit aus der Vorrichtung rauszufahren und mit der schwenkbaren Abschirmung abzudecken, dass eine Reinigung und Trocknung mit Lösungsmittel möglich ist. Die Vorrichtung weist mit Vorzug einen, insbesondere einschwenkbaren, Arm mit mindestens einer Düse auf, der für die Reinigung der oberen Seite des Substratstapels verwendet werden kann. Der Arm kann in einer weiteren Ausführungsform als Arm mit hydraulisch ausfahrbarem Teleskopausleger in den, insbesondere abgeschlossenen, Raum über den Substratstapeln eingeführt werden.

Unter und/oder über der Aufnahmeeinrichtung und/oder im untersten und/oder obersten Ring kann sich zumindest eine weitere Düse, insbesondere eine BSR (back side rinse) Düse, befinden, die insbesondere in Richtung zum Zentrum des Substratstapels zeigt, sodass auch die untere und/oder die obere Seite des Substratstapels gereinigt werden kann. Besonders vorteilhaft ist es, wenn mindestens zwei Lösungsmittel-Leitungen für die Düse bzw. Düsen vorhanden sind. Mit Vorzug werden auf der unteren und/oder oberen Seite der Aufnahmeeinrichtung und/oder im untersten und/oder obersten Ring 1 bis 60 Düsen eingesetzt, mit größerem Vorzug 1 bis 10, mit größtem Vorzug 1 bis 6, mit allergrößtem Vorzug 1 bis 3 Düsen angeordnet. In einer weiteren bevorzugten Ausführungsform kann diese Düse bzw. können diese Düsen bewegt werden, insbesondere von der Mitte der Aufnahmeeinrichtung zum Rand hin, wobei sie bevorzugt eine gleichförmige, insbesondere lineare, Bewegung ausführen. Andere Bewegungsabläufe wie z.B. eine spiralförmige Bewegung der Düse bzw. Düsen sind möglich. Für eine gute Flächendeckung kann eine bzw. können rotierende und/oder schwenkende Düse bzw. Düsen verwendet werden. Auch die Substrat-Halterungen selber können mit diesen Düsen gereinigt werden. Der Abstand zwischen den Düsen und der Oberfläche eines Substrats kann vorzugsweise ebenfalls eingestellt werden. Der maximale Verfahrweg einer Düse ist dabei größer als 0 mm, vorzugsweise größer als 1 mm, noch bevorzugter mehr als 25 mm, am bevorzugtesten mehr als 50 mm, am allerbevorzugtesten mehr als 100 mm.

Der Substratstapel wird, insbesondere auf der Aufnahmeeinrichtung, während der Reinigung, insbesondere an seinem Umfang, mit Vorzug von 15, mit größerem Vorzug von 9, mit größtem Vorzug von 6, mit allergrößtem Vorzug von 3 Fixierungspins festgehalten. Dadurch kann vorteilhaft eine besonders effiziente Reinigung erfolgen. Bevorzugt ist die Aufnahmeeinrichtung so gestaltet, dass ein Roboter den Substratstapel entnehmen kann. In einer weiteren erfindungsgemäßen Ausführung werden in der Aufnahmeeinrichtung keine Ladestifte verwendet, um Verunreinigungen möglichst gering zu halten oder zu verhindern.

Mit der vorliegenden Erfindung wird gemäß einer bevorzugten Ausführungsform Lösungsmittel, das bei einem Reinigungsprozess anfällt, nicht mehr entsorgt, sondern, insbesondere durch Destillation, abgetrennt und wiederverwendet. Organische sowie wässrige Lösungsmittel werden insbesondere durch fraktionierte Destillation und anschließende Kondensation aufbereitet. Das Abtrennen und Recycling kann in einen vollautomatischen Reiniger integriert werden. Ein Vorteil ist die Reduktion der Kosten. Außerdem steht bereits erwärmtes Lösungsmittel zur Verfügung, was den Reinigungsprozess und/oder den (An-)Löseprozess beschleunigt. Alternativ können Lösungsmittel durch weitere Lösungsmittel Reinigungsmethoden wie z.B. Rektifikation, Filtration, Zentrifugalreinigung, Adsorption, usw. gereinigt werden.

In einer weiteren vorteilhaften Ausführungsform der Erfindung ist vorgesehen, dass das Lösungsmittel zum Reinigen des Substratstapels und/oder des Produktsubstrats nach dem vollständigen Ablösen (engl. debonden) in einem Kreis gepumpt wird und - in einer Weiterentwicklung - durch Düsen, die in einem Düsenkörper über der, insbesondere ganzen, Substratoberfläche angeordnet sind, austritt. Dies kann insbesondere auch in einer separaten Station bzw. Modul stattfinden. In einer weiteren Ausführungsform ist vorgesehen, dass die Düsen über einer Teilfläche der Substratfläche angeordnet sind. Somit kann insbesondere ein Reinigungsdreieck entstehen. Durch die tortenförmige Ausgestaltung des Düsenkörpers kann beim Rotieren des Substrats bzw. Substratstapels eine gleichmäßige Verteilung des Lösungsmittels über die Substratoberfläche erreicht werden. Die Aufnahmeeinrichtung wird in dieser weiteren erfindungsgemäßen Ausführungsform durch einen Motor (nicht dargestellt) in Rotation versetzt. Eine sehr häufig verwendete Art der Fixierung vom Substrat auf der Aufnahmeeinrichtung erfolgt mit Hilfe von Vakuum bzw. Unterdruck. Die Substrataufnahmeeinrichtung hat Vakuumbahnen auf der gesamten Fläche oder auf definierten Zonen der Fläche, z.B. die Außenzonen der Fläche. Mit Vorteil verläuft der Unterdruckkanal konzentrisch, insbesondere kreisförmig, zu einem Zentrum Z der Aufnahmeeinrichtung, insbesondere vollumfänglich. Hierdurch wird eine gleichmäßige Fixierung erreicht. Weiterhin kann bei Bedarf die Kontur der Aufnahmefläche gegenüber der Aufnahmeebene der Aufnahmefläche zurückgesetzt sein, sodass Vertiefungen gebildet werden, die die Auflagefläche verkleinern bzw. verändern. Je nach Bedarf kann die Aufnahmefläche der Aufnahmeeinrichtung reduziert werden, sodass sich eine kleinere Kontaktfläche zwischen Substrat und Probenhalter ergibt. Weitere Möglichkeiten der Fixierung am Probenhalter sind die mechanische Fixierung durch Klemmen oder eine elektrostatischen Fixierung. Auch Probenhalter mit Pins werden eingesetzt. Spezialklebstoffe können auch eingesetzt werden. Die Anzahl und Verteilung der Düsen im Düsenkörper beeinflusst die Qualität und Homogenität der Reinigung. Mit Vorzug werden mehr als eine Düse, mit größerem Vorzug mehr als 5 Düsen, mit größtem Vorzug mehr als 10 Düsen, mit allergrößtem Vorzug mehr als 50 Düsen eingesetzt. Der Spritzabstand zwischen Düse und Substratoberfläche beträgt mit Vorzug zwischen 0,1 bis 100 mm, mit größerem Vorzug zwischen 0,1 bis 50 mm, mit größtem Vorzug zwischen 0,2 bis 20 mm. Der Spritzwinkel und die Spritzbreiten können je nach Düsenart und Spritzabstand variieren.

Das Lösungsmittel wird in der Lösungsmittelleitung bzw. im Common Rail insbesondere für die Grob-Reinigung im Kreis gepumpt. Das Lösungsmittel gelangt durch Versorgungsleitungen in den Düsenkörper. Mit Vorzug werden 1 bis 60, mit größerem Vorzug 1 bis 20, mit größtem Vorzug 1 bis 10, mit allergrößtem Vorzug 1 bis 6 Versorgungsleitungen eingesetzt. Die übereinander gestapelten Ringe sind insbesondere in einer geschlossenen Kammer angeordnet und der unterste Ring wird in einer bevorzugten Ausführungsform zum Reinigen des Substratstapels verwendet. Wird der Ring zum Reinigen des Produktsubstrats nach dem Ablösen verwendet, wird das Produktsubstrat insbesondere auf eine Klebefolie, bevorzugt mit einem Film-Frame, gespannt und kann in einem Reinigungsmodul mit einem Reinigungs-Ring gereinigt werden. Die Reinigungszeit kann mit diesem Reinigungs-Ring erheblich verkürzt werden. Der Durchmesser der Düsen für den Reinigungsschritt beträgt insbesondere 0,1 bis 5 mm, bevorzugt 0,2 bis 1 mm. Das Reinigen kann im gleichen Modul durchgeführt werden und/oder auf einer separaten Station. Es können auch mehrere Reinigungsschritte im gesamten Prozess durchgeführt werden. In einer weiteren Ausführungsform kann bei Bedarf der Reinigungsring rotiert werden.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Figur 1a:: eine schematische Aufsicht einer Vorrichtung gemäß einer ersten Ausführungsform mit einer Schnittlinie A-A,
- Figur 1b:: eine schematische Querschnittansicht eines Teilabschnitts der Vorrichtung aus Figur 1a entlang der Schnittlinie A-A,
- Figur 1c:: eine schematische Querschnittansicht einer erfindungsgemäßen Vorrichtung gemäß einer zweiten Ausführungsform,
- Figur 2a:: eine Querschnittsansicht einer erfindungsgemäßen Vorrichtung gemäß einer dritten Ausführungsform,
- Figur 2b:: eine Aufsicht auf eine Aufnahmeeinrichtung gemäß einer bevorzugten Ausführungsform,
- Figur 3:: eine Querschnittsansicht einer erfindungsgemäßen Vorrichtung gemäß einer vierten Ausführungsform,
- Figur 4a:: eine Querschnittsansicht einer Aufnahmeeinrichtung,

- Figur 4b:: eine Aufsicht der Aufnahmeeinrichtung aus Figur 4a,
- Figur 5a:: eine schematische Aufsicht eines Düsenkörpers und
- Figur 5b:: eine Querschnittsansicht eines weiteren beispielhaften Düsenkörpers.

In den Figuren sind gleiche Bauteile und Bauteile mit der gleichen Funktion mit den gleichen Bezugszeichen gekennzeichnet und werden daher jeweils auch nur einmal benannt.

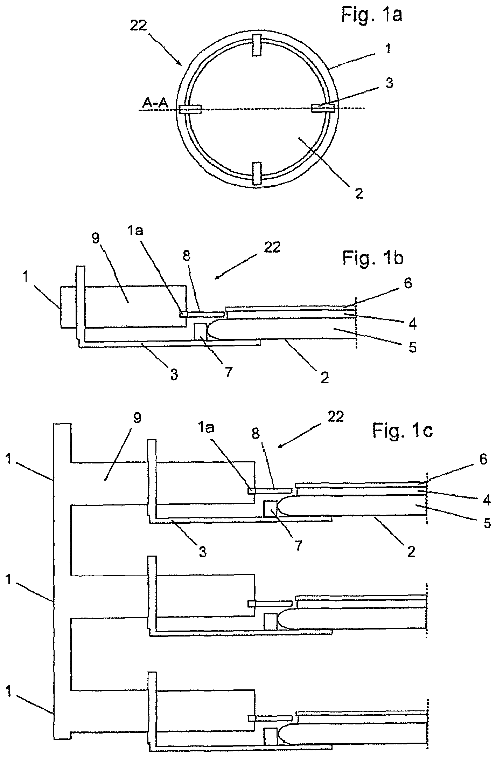

Figur 1a zeigt schematisch eine Aufsicht einer Vorrichtung 22 gemäß einer ersten Ausführungsform mit einer Schnittlinie A-A. Figur 1b zeigt einen schematischen Halbteil einer Querschnittsansicht der Vorrichtung 22 entlang der Schnittlinie A-A. Der andere Halbteil ist spiegelbildlich ausgeführt.

Wie in den Figuren 1a und 1b gezeigt, weist die Vorrichtung 22 einen Ring 1 auf. Der Ring 1 ist mit schwenkbaren Halterungen 3 mit Fixierungspins 7 ausgestattet, um einen Substratstapel 2 in einer Anlöseposition zu halten. Die Fixierungspins 7 sind vorteilhaft zylindrisch oder leicht konisch angespitzt, können aber auch andere geeignete Formen und/oder Größen haben. Der Substratstapel 2 besteht aus einem Trägersubstrat 5 und einem Produktsubstrat 6, die über eine Verbindungsschicht 4, z.B. eine Klebeschicht, temporär miteinander verbondet sind.

Der Ring 1 ist mit Vorzug in 0,1 bis 15 mm, mit größerem Vorzug in 0,1 bis 10 mm, mit größtem Vorzug in 0,1 bis 8 mm, mit allergrößtem Vorzug in 0,1 bis 5 mm Abstand zum Substratstapel 2 angebracht.

Der Ring 1 ist mit einer Lösungsmittel-Leitung 9 (im Folgenden auch Common Rail 9 genannt) ausgestattet, in die Bohrungen, vorzugsweise Düsen 1a, führen. Die Bohrungen, vorzugsweise Düsen 1a, haben mit Vorzug einen Durchmesser von 0,01 bis 10 mm, mit größerem Vorzug von 0,01 bis 7 mm, mit größtem Vorzug von 0,01 bis 5 mm, mit allergrößtem Vorzug von 0,1 bis 2 mm. Die Düsen 1a sind am ganzen Umfang des Rings 1 angeordnet. Der Abstand der Düsen 1a zueinander hängt vom Material und der abzulösenden Randzone (im Folgenden auch Randbereich oder Edge Zone genannt) ab und liegt im Bereich von 1 bis 50 mm, bevorzugt im Bereich von 3 bis 20 mm. Die Düse 1a spritzt Lösungsmittel auf den Randbereich der Verbindungsschicht 4 (angedeutet mit einem Lösungsmittelstrahl 8).

Der Durchmesser des Produktsubstrats 6 stimmt vorzugsweise mit dem Durchmesser des Trägersubstrats 5 im Wesentlichen überein. Die Dicke des Produktsubstrats 6 ist insbesondere geringer als die Dicke des Trägersubstrats 5.

Die Lösungsmittel-Leitungen 9 werden mit Lösungsmittel gefüllt und das Lösungsmittel tritt aus den Düsen 1a mit hohem Druck aus. Der Druck ist dabei größer gleich 1 bar, vorzugsweise größer als 5 bar, noch bevorzugter größer als 10 bar, am bevorzugtesten größer als 20 bar. Wird die Anlage unter Vakuum betrieben und ist der Umgebungsdruck kleiner als 1 bar, so kann der Druck des Lösungsmittels, sofern notwendig ebenfalls kleiner als 1 bar sein. Der Druck des Lösungsmittels muss aber auf alle Fälle größer sein als der Umgebungsdruck. Das Lösungsmittel wird im Kreis gepumpt (nicht dargestellt) und grob gefiltert, um eine Verstopfung der Düsen 1a zu verhindern. Für eine erfindungsgemäße Ausführungsform, in welcher das Lösungsmittel durch Destillation abgetrennt und wiederverwendet wird, ist das Lösungsmittel bereits beheizt.

Die Prozesszeit z.B. beim Anlösevorgang (Edge Zone Release (EZR) Vorgang) hängt vom Material, i.e. vom Klebstoff, und von der Breite der (Kleber-) Randzone ab. Die Randzone kann so schmal wie möglich gestaltet werden, um die Prozesszeit bzw. Anlösezeit zu verringern.

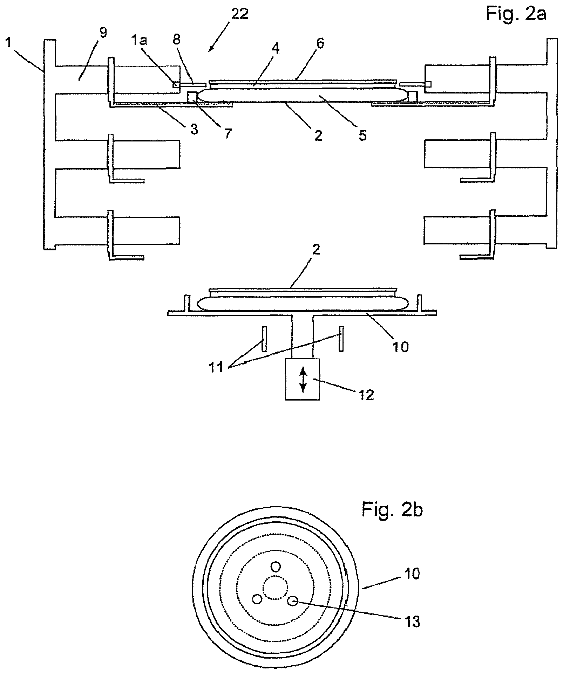

In der Figur 1b ist der Ring 1 und/oder die Halterung 3' drehbar ausgebildet. Als Halterung 3' i.e. Aufnahmeeinrichtung eignet sich insbesondere ein Probenhalter (engl.: chuck). Um ein vollständiges und/oder schnelleres Lösen bzw. Anlösen zu ermöglichen, erfolgt eine Relativrotation zwischen den Düsen 1a und dem Substratstapel 2. Mit Vorzug befindet sich der Substratstapelhalter 3' auf einer Welle, welche um Ihre Achse in Rotation versetzt werden kann. In dieser Ausführungsform ist die Halterung 3' nicht schwenkbar sondern wird mit einer Welle zentrisch geführt (nicht dargestellt). Vorteilhaft wird die Aufnahmeeinrichtung 10 eingesetzt (siehe Figur 2a). Die Aufnahmeeinrichtung 10 bewegt sich zuerst, insbesondere angetrieben über eine Welle 12, in der z-Richtung nach oben und bringt den Substratstapel 2 in die Betriebsposition. Diese Welle kann dann auch um Ihre Achse in Rotation versetzt werden (nicht dargestellt). Anstatt der Drehung ist auch eine Oszillation der Halterung 3' um die Welle möglich. Dabei kann eine Drehung bzw. Oszillation so eingestellt werden, dass durch die Oszillation zumindest jener Winkel, der zwischen zwei Düsen 1a liegt, abgedeckt wird. Dadurch wird der gesamte Verbindungsschichtumfang abgedeckt und es können weniger Düsen 1a eingesetzt werden.

Figur 1c zeigt einen Halbteil einer schematischen Querschnittansicht einer erfindungsgemäßen Vorrichtung 22 gemäß einer zweiten Ausführungsform. Der andere Halbteil ist spiegelbildlich ausgeführt. In Figur 1c sind drei, insbesondere identisch ausgebildete, Ringe 1 sowie korrespondierende Halterungen 3 vertikal übereinander gestapelt angeordnet. Alle Ringe 1 sind in einer geschlossenen Kammer untergebracht (nicht dargestellt). Die gestapelten Ringe 1 sind miteinander verbunden und werden mittels Verbindungs- bzw. Versorgungsleitungen 9 mit Lösungsmittel mittels einer leistungsstarken Umwälzpumpe versorgt.

Mehrere Ringe 1 können in beliebiger Anzahl übereinander angeordnet werden, mit Vorzug 2 bis 30, mit größerem Vorzug 2 bis 15, mit größtem Vorzug 2 bis 10, mit allergrößtem Vorzug 2 bis 5 Ringe 1, sodass mehrere Substratstapel 2 gleichzeitig behandelt werden können.

Figur 2a zeigt schematisch eine Querschnittsansicht einer erfindungsgemäßen Vorrichtung 22 gemäß einer dritten Ausführungsform. Die Vorrichtung 22 kann wie in der Figur 1c beschrieben ausgebildet sein, wobei die Vorrichtung 22 zusätzlich eine Aufnahmeeinrichtung 10 aufweist. Der obere Ring 1 ist in dieser Darstellung bereits mit einem Substratstapel 2 beladen. Ein zweiter Substratstapel befindet sich auf der Aufnahmeeinrichtung 10.

Der Substratstapel 2 kann zuvor von einem Roboter (nicht dargestellt) auf die Aufnahmeeinrichtung (insbesondere ein Chuck) 10 geladen worden sein. Die Aufnahmeeinrichtung 10 ist so ausgebildet, dass der Roboter den Substratstapel 2 nach dem Lösen bzw. Anlösen wieder entnehmen kann. Vorteilhaft wird der Substratstapel 2 auf der parallel zur z-Richtung (Vertikalrichtung) beweglichen Aufnahmeeinrichtung 10 fixiert. Die Aufnahmeeinrichtung 10 bewegt sich, insbesondere angetrieben über eine Welle 12, in der z-Richtung nach oben und bringt den Substratstapel 2 in die Nähe der mittleren Halterung 3. Danach laden bewegliche Ladestifte 11 den Substratstapel 2 auf die mittlere Halterung 3.

In einer vorteilhaften Ausführung der Erfindung ist vorgesehen, dass die Halterungen 3 eingeschwenkt werden können und die Ladestifte 11 den Substratstapel 2 darauf absetzen können. Die Fixierungspins 7 verhindern ein Verrutschen des Substratstapels 2 auf der Halterung 3. In einer weiteren beispielhaften Ausführung ist alternativ oder optional eine Vakuumeinrichtung auf den, insbesondere schwenkbaren, Halterungen 3 angeordnet.

Dieser Vorgang wird wiederholt bis alle Substratstapel 2 geladen bzw. alle Ringe 1 beladen sind. Danach wird das Spritzen des Lösungsmittels aus den Düsen 1a gestartet.

Figur 2b zeigt eine Aufsicht auf eine Aufnahmeeinrichtung 10 einer bevorzugten Ausführungsform. Die Aufnahmeeinrichtung 10 verfügt, um einen Substratstapel 2 von der Halterung 3 aufzunehmen bzw. auf der Halterung 3 abzulegen, über einen nicht dargestellten Hebemechanismus mit Ladestiften 11. Der Hebemechanismus kann z.B. in der Aufnahmeeinrichtung 10 integriert werden und mittels eines Steuerungsnetzwerkes betrieben werden. Die Aufnahmeeinrichtung 10 wie in Figur 2b gezeigt verfügt über drei Aussparungen 13 für die Ladestifte 11. Weiters weist die Auflagefläche der Aufnahmeeinrichtung 10 gemäß einer beispielhaften Ausführungsform kreisförmige, konzentrisch zum Zentrum angeordnete, Aussparungen auf. Diese Aussparungen sind vorteilhaft, um eine Reinigung des Substratstapels 2 von unten durchführen zu können. Die Aussparungen können auch andere geeignete Formen aufweisen, z.B. wabenförmig oder kreisförmig ausgebildet sein, und/oder andere Flächendeckungen haben.

Nach dem Spritzvorgang wird der unterste Substratstapel 2 von den Ladestiften 11 angehoben. Danach werden die Halterungen 3 ausgeschwenkt und die Ladestifte 11 setzen den Substratstapel 2 auf der Aufnahmeeinrichtung 10 ab. Die Aufnahmeeinrichtung 10 fährt in eine definierte untere Position, um die Reinigung des Substratstapels 2 zu ermöglichen bzw. durchzuführen.

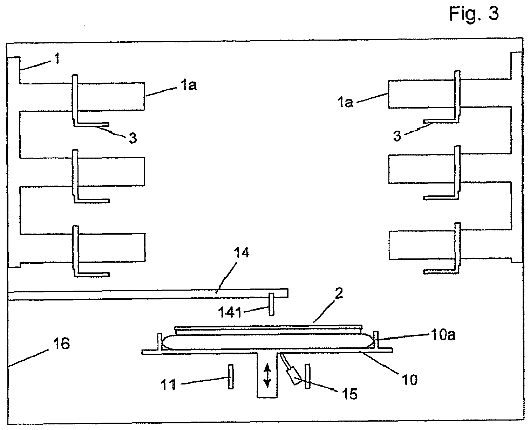

Figur 3 zeigt schematisch eine Querschnittsansicht einer erfindungsgemäßen Vorrichtung 22 gemäß einer vierten Ausführungsform. Figur 3 zeigt eine Ausführungsform, in der der Substratstapel 2 mit Lösungsmittel, z.B. reinem Lösungsmittel oder einem Lösungsmittel-Gemisch, gereinigt und mit schnell trocknenden Lösungsmitteln getrocknet wird. Die Aufnahmeeinrichtung 10 fährt in eine definierte untere Position, um die Reinigung des Substratstapels 2 zu ermöglichen bzw. durchzuführen. Die übereinander gestapelten Ringe 1 sowie die Aufnahmeeinrichtung 10 sind in einer geschlossenen Kammer 16 angeordnet.

Oberhalb dieser unteren Position befindet sich ein einschwenkbarer Arm 14 mit einer Düse 141 für die Substratstapel-Reinigung durch Lösungsmittel. Besonders bevorzugt ist die Verwendung einer einschwenkbaren Abschirmung (nicht dargestellt) in der Vorrichtung 22, sodass, wenn das Lösen bzw. Anlösen beendet ist und der unterste Substratstapel 2 zur Reinigung entnommen wird, die Abschirmung die Verunreinigung vom untersten Substratstapel 2 durch Tropfen von oben verhindert. Ist die Abschirmung eingeschwenkt, kann der Substratstapel 2 gereinigt bzw. dann getrocknet werden. Zum Aufnehmen des nächsten Substratstapels 2 geht die Abschirmung wieder auf.

Vorteilshalber ist vorgesehen, den jeweils untersten Substratstapel 2 mit der in z-Richtung beweglichen Aufnahmeeinrichtung 10 soweit nach unten aus dem Ringstapel rauszufahren und mit der schwenkbaren Abschirmung abzudecken, dass eine Reinigung und Trocknung mit Lösungsmittel möglich ist. Der einschwenkbare Arm 14 mit der Düse 141 wird für die Reinigung der oberen Seite vom Substratstapel 2 verwendet. Unter der Aufnahmeeinrichtung 10 befindet sich eine weitere Düse 15, die in Richtung zum Zentrum des Substratstapels 2 zeigt, sodass auch die untere Seite vom Substratstapel 2 gereinigt werden kann. In dieser beispielhaften Ausführungsform wird der Substratstapel 2 während des Reinigungsschritts nur am Umfang von drei Fixierungspins 10a festgehalten.

Der Substratstapel 2 wird von der Aufnahmeeinrichtung 10 mit einem Roboter entladen und z.B. auf einen Film-Frame Mounter oder zum nächsten Modul (z.B. für Edge Zone Debonding EZD) geführt. Alternativ dient z.B. eine Bufferstation zum Zwischenlagern des Substratstapels 2, bevor dieser im Prozess weiter verarbeitet wird, i.e. z.B. bis wieder Plätze zum Weiterverarbeiten in der, insbesondere automatischen, Anlage frei sind.

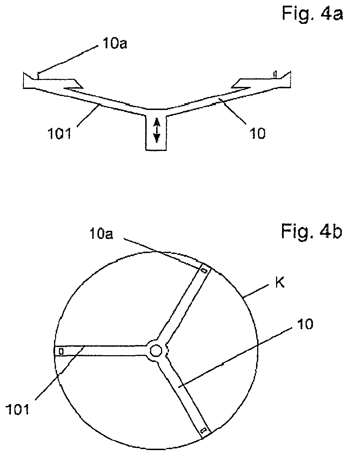

Figur 4a zeigt schematisch eine weitere beispielhafte Ausführungsform der Aufnahmeeinrichtung 10 in einer Seitenansicht. Figur 4b zeigt eine Aufsicht der in z-Richtung beweglichen Aufnahmeeinrichtung 10 aus der Figur 4a. Der Substratstapel 2 (nicht dargestellt) wird nur am Umfang mit drei Fixierungspins 10a festgehalten. Die Aufnahmeeinrichtung 10 weist drei längliche Arme 101 auf, die sich vom Zentrum der Aufnahmeeinrichtung 10 radial nach außen erstrecken und im Winkelabstand von 120° zueinander gleichmäßig beabstandet sind. Die Enden der Arme 101 liegen auf einem Kreis K. Die Arme 101 sind gleich lang ausgebildet. Die Arme 101 sind stabförmig mit gleich bleibendem Querschnitt ausgebildet. An den radial außen liegenden Enden der Arme 101 ist eine horizontal angeordnete Auflagefläche für den Substratstapel 2 angeordnet. Auf dieser Auflagefläche befindet sich der Fixierungspin 10a. Diese Ausführungsform ermöglicht eine besonders effiziente Reinigung des Substratstapels 2 Die Kontur der Auflagefläche und die Form der Aufnahmeeinrichtung 10 sind im Übrigen nicht auf die Ausführungsbeispiele gemäß Figur 2b und Figur 4b beschränkt.

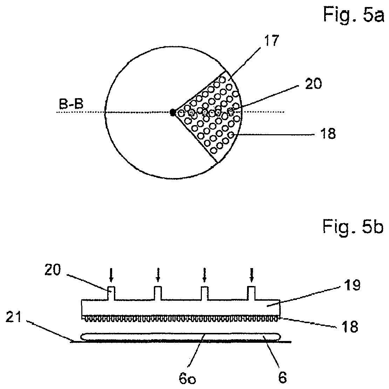

Figuren 5a und 5b zeigen Düsenkörper 17, 19 gemäß zweier Weiterbildungen der erfindungsgemäßen Vorrichtung 22. Die Düsenkörper 17, 19 können oberhalb des Produktsubstrats 6 mit der Substratoberfläche 6o angeordnet werden. Dadurch kann das Produktsubstrat 6 besonders effizient, insbesondere von oben, gereinigt werden, insbesondere nachdem der Substratstapel 2 vollständig getrennt worden ist.

Figur 5a zeigt gemäß einer ersten Ausführungsform einen Düsenkörper 17 (mit einem so genannten Reinigungsdreieck), dessen Düsen 18 lediglich auf einem Teilbereich des Düsenkörpers 17 bzw. der Oberfläche des Düsenkörpers 17 angeordnet sind. Dieser Teilbereich umfasst insbesondere ein Kreisflächensegment, welches sich vom Zentrum aus über einen Winkel von etwa 90° erstreckt. Der Düsenkörper 17 und/oder das Produktsubstrat 6 können insbesondere rotiert werden, um eine besonders gründliche Reinigung der Oberfläche 6o zu erreichen.

Figur 5b zeigt einen Düsenkörper 19 gemäß einer zweiten Ausführungsform, dessen Düsen 18 nicht nur über einen Teilbereich sondern über die gesamte Oberfläche des Düsenkörpers 19 verteilt angeordnet sind. Der Düsenkörper 19 ist vollflächig mit den Düsen 18 ausgestattet.

Das Lösungsmittel bzw. Lösungsmittel-Gemisch wird im Common Rail 9 insbesondere für die Grob-Reinigung im Kreis gepumpt. Das Lösungsmittel wird durch Versorgungsleitungen 20 in den Düsenkörper 17 bzw. 19 gepumpt.

Die Vorrichtung 22 weist den Düsenkörper 17 oder 19 insbesondere zum Reinigen des Produktsubstrats 6 nach dem Ablösen (Edge Zone Debonding EZD) auf. Das Produktsubstrat 6 ist insbesondere auf eine Klebe-Folie 21 mit einem Film-Frame gespannt und wird insbesondere in einem separaten Reinigungsmodul gereinigt.

### Bezugszeichenliste

- 1: Ring
- 1a: Düse
- 2: Substratstapel
- 3, 3': Halterung
- 4: Verbindungsschicht
- 5: Trägersubstrat
- 6: Produktsubstrat
- 6o: Substratoberfläche
- 7: Fixierungspin
- 8: Lösungsmittelstrahl
- 9: Lösungsmittelleitung
- 10: Aufnahmeeinrichtung
- 10a: Fixierungspin
- 101: Arm
- 11: Ladestift
- 12: Welle
- 13: Aussparung
- 14: Arm
- 141: Düse
- 15: Düse
- 16: Kammer
- 17: Düsenkörper
- 18: Düse
- 19: Düsenkörper
- 20: Versorgungsleitung
- 21: Folie
- K: Kreis

## Patentansprüche

1. Vorrichtung (22) zum zumindest teilweisen Lösen einer Verbindungsschicht (4) eines temporär verbondeten Substratstapels (2), mit folgenden Merkmalen:
-- die Vorrichtung (22) weist mehrere Ringe (1) auf, wobei der Substratstapel (2) innerhalb des mindestens einen Rings (1) platzierbar ist,
-- der mindestens eine Ring (1) weist eine Mehrzahl von Düsen (1a) auf, wobei die Düsen (1a) zumindest über einen Teil des Umfangs des mindestens einen Rings (1) verteilt angeordnet sind,
-- die Düsen (1a) sind auf die Verbindungsschicht (4) ausgerichtet, wobei die Vorrichtung (22) derart ausgebildet ist, dass Lösungsmittel aus den Düsen (1a) auf einen Randbereich der Verbindungsschicht (4) spritzbar ist, wobei die Vorrichtung (22) mehrere übereinander angeordnete Ringe (1) aufweist.

2. Vorrichtung (22) nach Anspruch 1, **dadurch gekennzeichnet, dass** der Ring (1) in 0,1 bis 15 mm Abstand, mit Vorzug in 0,1 bis 10 mm, mit größerem Vorzug in 0,1 bis 8 mm, mit größtem Vorzug in 0,1 bis 5 mm Abstand zum Substratstapel (2) und/oder zur Verbindungsschicht (4) angebracht ist.

3. Vorrichtung (22) nach einem der vorhergehenden Ansprüche, **dadurch gekennzeichnet, dass** die Düsen (1a) einen Durchmesser von 0,01 bis 10 mm, mit Vorzug von 0,01 bis 7 mm, mit größerem Vorzug von 0,01 bis 5 mm, mit größtem Vorzug von 0,1 bis 2 mm aufweisen.

4. Vorrichtung (22) nach einem der vorhergehenden Ansprüche, **dadurch gekennzeichnet, dass** der Ring (1) eine Lösungsmittelleitung (9) aufweist, wobei die Lösungsmittelleitung (9) zu der Mehrzahl an Düsen (1a) führt.

5. Vorrichtung (22) nach einem der vorhergehenden Ansprüche, **dadurch gekennzeichnet, dass** die Düsen (1a), insbesondere gleichmäßig voneinander beabstandet, über den gesamten Umfang des Rings (1) verteilt angeordnet sind.

6. Vorrichtung (22) nach einem der vorhergehenden Ansprüche, **dadurch gekennzeichnet, dass** der Ring (1) mindestens 60, mit Vorzug mindestens 70, mit größerem Vorzug mindestens 80, mit noch größerem Vorzug mindestens 100 und mit größtem Vorzug mindestens 120 Düsen (1a) aufweist.

7. Vorrichtung (22) nach einem der vorhergehenden Ansprüche, **dadurch gekennzeichnet, dass** der Ring (1) mindestens eine, insbesondere schwenkbare, Halterung (3) aufweist, die zur Aufnahme des Substratstapels (2) in der Löseposition und/oder Anlöseposition innerhalb des mindestens einen Rings (1) ausgebildet ist.

8. Vorrichtung (22) nach Anspruch 7, **dadurch gekennzeichnet, dass** die mindestens eine Halterung (3) mindestens einen Fixierungspin (7) aufweist, der zum Befestigen des Substratstapels (2) ausgebildet ist.

9. Vorrichtung (22) nach einem der vorhergehenden Ansprüche, **dadurch gekennzeichnet, dass** die Ringe (1) vertikal übereinander angeordnet sind, bevorzugt gestapelt, wobei die Ringe (1) insbesondere in einer geschlossenen Kammer untergebracht sind.

10. Vorrichtung (22) nach Anspruch 9, **dadurch gekennzeichnet, dass** 2 bis 30 Ringe (1) übereinander angeordnet sind, wobei mit Vorzug 2 bis 15, mit größerem Vorzug 2 bis 10, mit größtem Vorzug 2 bis 5 Ringe (1) übereinander angeordnet sind.

11. Vorrichtung (22) nach einem der vorhergehenden Ansprüche, **dadurch gekennzeichnet, dass** die Düsen (1a) schwenkbar, insbesondere in der Horizontalebene schwenkbar, ausgebildet sind, wobei der Schwenkungsgrad der Düsen bevorzugt 1° bis 20°, besonders bevorzugt 1° bis 15° beträgt.

12. Vorrichtung (22) nach einem der vorhergehenden Ansprüche, **dadurch gekennzeichnet, dass** die Vorrichtung (22) eine, insbesondere in vertikaler Richtung, bewegliche Aufnahmeeinrichtung (10) zum Transport des Substratstapels (2) aufweist.

13. Vorrichtung (22) nach Anspruch 12, **dadurch gekennzeichnet, dass** sich unter der Aufnahmeeinrichtung (10) und/oder im untersten Ring eine oder mehrere Düsen (15) zur Reinigung der Unterseite des Substratstapels (2) befinden, die insbesondere in Richtung des Zentrums des Substratstapels (2) zeigt bzw. zeigen, wobei mit Vorzug unter der Aufnahmeeinrichtung (10) und/oder im untersten Ring 1 bis 60 Düsen, mit größerem Vorzug 1 bis 10, mit größtem Vorzug 1 bis 6, mit allergrößtem Vorzug 1 bis 3 Düsen angeordnet sind.

14. Vorrichtung (22) nach Anspruch 13, **dadurch gekennzeichnet, dass** während der Reinigung des Substratstapels (2) der Substratstapel (2), insbesondere an seinem Umfang, mit 15 Fixierungspins (7), mit Vorzug mit 9 Fixierungspins (7), mit größerem Vorzug mit 6 Fixierungspins (7), mit größtem Vorzug mit 3 Fixierungspins (7) festgehalten wird.

15. Vorrichtung (22) nach einem der vorhergehenden Ansprüche, aufweisend einen, insbesondere einschwenkbaren, Arm mit mindestens einer Düse, der für die Reinigung der oberen Seite des Substratstapels (2) ausgebildet ist.

16. Verfahren zum zumindest teilweisen Lösen einer Verbindungsschicht (4) eines temporär verbondeten Substratstapels (2), mit folgenden Schritten, insbesondere mit folgendem Ablauf:
-- Platzieren des Substratstapels (2) innerhalb mindestens eines Rings (1) mit einer Mehrzahl von Düsen (1a), wobei die Düsen (1a) zumindest über einen Teil des Umfangs des mindestens einen Rings (1) verteilt angeordnet werden,
-- Ausrichten der Düsen (1a) auf die Verbindungsschicht (4),
-- Spritzen von Lösungsmittel auf einen Randbereich der Verbindungsschicht (4),
wobei mehrere Ringe (1) übereinander angeordnet werden.

## Claims

1. Device (22) for at least partial loosening of a connecting layer (4) of a temporarily bonded substrate stack (2), with the following features:
- The device (22) has several rings (1), whereby the substrate stack (2) can be placed within the at least one ring (1),
- The at least one ring (1) has a number of nozzles (1a), whereby the nozzles (1a) are arranged distributed at least over a portion of the periphery of the at least one ring (1),
- The nozzles (1a) are directed onto the connecting layer (4), wherein the device (22) is designed in such a way that solvent can be sprayed from the nozzles (1a) onto an edge area of the connecting layer (4), wherein the device (22) has multiple rings (1) that are arranged one above the other.

2. Device (22) according to Claim 1, **characterized in that** the ring (1) is mounted 0.1 to 15 mm, preferably 0.1 to 10 mm, more preferably 0.1 to 8 mm, and with utmost preference 0.1 to 5 mm away from the substrate stack (2) and/or the connecting layer (4).

3. Device (22) according to one of the preceding claims, wherein the nozzles (1a) have a diameter of 0.01 to 10 mm, preferably 0.01 to 7 mm, more preferably 0.01 to 5 mm, and with utmost preference 0.1 to 2 mm.

4. Device (22) according to one of the preceding claims, wherein the ring (1) has a solvent line (9), whereby the solvent line (9) leads to the number of nozzles (1a).

5. Device (22) according to one of the preceding claims, wherein the nozzles (1a) are arranged distributed, in particular evenly spaced, from one another over the entire periphery of the ring (1).

6. Device (22) according to one of the preceding claims, wherein the ring (1) has at least 60, preferably at least 70, more preferably at least 80, even more preferably at least 100, and with utmost preference at least 120 nozzles (1a).

7. Device (22) according to one of the preceding claims, wherein the ring (1) has at least one, in particular pivoting, holding device (3), which is designed to receive the substrate stack (2) in the loosening position and/or partial loosening position within the at least one ring (1).

8. Device (22) according to Claim 7, wherein the at least one holding device (3) has at least one attaching pin (7), which is designed to fasten the substrate stack (2).

9. Device (22) according to one of the preceding claims, wherein the rings (1) are arranged vertically one above the other, preferably stacked, wherein the rings (1) are installed in particular in a closed chamber.

10. Device (22) according to Claim 9, wherein 2 to 30 rings (1) are arranged one above the other, whereby preferably 2 to 15, more preferably 2 to 10, and with utmost preference 2 to 5 rings (1) are arranged one above the other.

11. Device (22) according to one of the preceding claims, wherein the nozzles (1a) are designed to pivot, in particular to pivot in the horizontal plane, whereby the degree of pivoting of the nozzles is preferably 1° to 20°, especially preferably 1° to 15°.

12. Device (22) according to one of the preceding claims, wherein the device (22) has a receiving system (10), movable in particular in the vertical direction, for transport of the substrate stack (2).

13. Device (22) according to Claim 12, wherein one or more nozzles (15) for cleaning the bottom of the substrate stack (2) are located below the receiving system (10) and/or in the lowermost ring, which nozzle(s) points or point in particular in the direction of the center of the substrate stack (2), whereby preferably 1 to 60 nozzles, more preferably 1 to 10 nozzles, most preferably 1 to 6 nozzles, and with utmost preference 1 to 3 nozzles are arranged under the receiving system (10) and/or in the lowermost ring.

14. Device (22) according to Claim 13, wherein during the cleaning of the substrate stack (2), the substrate stack (2), in particular on its periphery, is secured with 15 attaching pins (7), preferably with 9 attaching pins (7), more preferably with 6 attaching pins (7), and most preferably with 3 attaching pins (7).

15. Device (22) according to one of the preceding claims, having an in particular pivoting arm with at least one nozzle, which is designed for the cleaning of the upper side of the substrate stack (2).

16. Method for at least partial loosening of a connecting layer (4) of a temporarily bonded substrate stack (2), with the following steps, in particular with the following sequence:
- Placing the substrate stack (2) within at least one ring (1) with a number of nozzles (1a), whereby the nozzles (1a) are arranged distributed at least over a portion of the periphery of the at least one ring (1),
- Directing the nozzles (1a) to the connecting layer (4),
- Spraying solvent on an edge area of the connecting layer (4), wherein multiple rings (1) are arranged one above the other.

## Revendications

1. Dispositif (22) pour la dissolution au moins partielle d'une couche de liaison (4) d'une pile de substrats (2) collée de façon temporaire, comprenant les caractéristiques suivantes :
-- le dispositif (22) présente plusieurs anneaux (1), dans lequel la pile de substrats (2) peut être placée à l'intérieur de l'au moins un anneau (1),
-- l'au moins un anneau (1) présente une pluralité de buses (1a), dans lequel les buses (1a) sont disposées en étant réparties au moins sur une partie du pourtour de l'au moins un anneau (1),
-- les buses (1a) sont alignées sur la couche de liaison (4), dans lequel le dispositif (22) est ainsi conçu que des solvants peuvent être pulvérisés sur un bord de la couche de liaison (4) à partir des buses (1a), dans lequel le dispositif (22) présente plusieurs anneaux (1) disposés les uns sur les autres.

2. Dispositif (22) selon la revendication 1, **caractérisé en ce que** l'anneau (1) est appliqué avec un écart de 0,1 à 15 mm, de préférence de 0,1 à 10 mm, de manière plus préférée de 0,1 à 8 mm, de manière la plus préférée de 0,1 à 5 mm par rapport à la pile de substrats (2) et/ou la couche de liaison (4).

3. Dispositif (22) selon l'une des revendications précédentes, **caractérisé en ce que** les buses (1a) présentent un diamètre de 0,01 à 10 mm, de préférence de 0,01 à 7 mm, de manière plus préférée de 0,01 à 5 mm, de manière la plus préférée de 0,1 à 2 mm.

4. Dispositif (22) selon l'une des revendications précédentes, **caractérisé en ce que** l'anneau (1) présente une ligne pour solvants (9), dans lequel la ligne pour solvants (9) conduit à la pluralité de buses (1a).

5. Dispositif (22) selon l'une des revendications précédentes, **caractérisé en ce que** les buses (1a) sont agencées en étant réparties sur tout le pourtour de l'anneau (1), en particulier espacées régulièrement l'une de l'autre.

6. Dispositif (22) selon l'une des revendications précédentes, **caractérisé en ce que** l'anneau (1) présente au moins 60, de préférence au moins 70, de manière plus préférée au moins 80, de manière plus préférée encore au moins 100 et de manière préférée entre toutes au moins 120 buses (1a).

7. Dispositif (22) selon l'une des revendications précédentes, **caractérisé en ce que** l'anneau (1) présente au moins une fixation (3) en particulier pivotante, qui est conçue pour la réception de la pile de substrats (2) dans la position pour dissoudre et/ou la position pour corroder à l'intérieur de l'au moins un anneau (1).

8. Dispositif (22) selon la revendication 7, **caractérisé en ce que** l'au moins une fixation (3) présente au moins une broche de fixation (7) qui est conçue pour fixer la pile de substrats (2).

9. Dispositif (22) selon l'une des revendications précédentes, **caractérisé en ce que** les anneaux (1) sont disposés verticalement l'un au-dessus de l'autre, de préférence empilés, dans lequel les anneaux (1) sont en particulier placés dans une chambre fermée.

10. Dispositif (22) selon la revendication 9, **caractérisé en ce que** 2 à 30 anneaux (1) sont disposés l'un au-dessus de l'autre, dans lequel de préférence 2 à 15, de manière plus préférée 2 à 10, de manière la plus préférée 2 à 5 anneaux (1) sont disposés l'un au-dessus de l'autre.

11. Dispositif (22) selon l'une des revendications précédentes, **caractérisé en ce que** les buses (1a) sont conçues pivotantes, en particulier pivotantes dans le plan horizontal, dans lequel le degré de pivotement des buses est de préférence de 1° à 20°, particulièrement de préférence de 1° à 15°.

12. Dispositif (22) selon l'une des revendications précédentes, **caractérisé en ce que** le dispositif (22) présente un dispositif de réception (10) mobile, en particulier dans le sens vertical, pour le transport de la pile de substrats (2).

13. Dispositif (22) selon la revendication 12, **caractérisé en ce qu'**une ou plusieurs buse(s) (15) pour nettoyer la sous-face de la pile de substrats (2) se trouve(nt) sous le dispositif de réception (10) et/ou dans l'anneau le plus inférieur, laquelle/lesquelles est/sont orientée(s) en particulier en direction du centre de la pile de substrats (2), dans lequel de préférence 1 à 60 buses, de manière plus préférée 1 à 10, de manière la plus préférée 1 à 6, de manière préférée entre toutes 1 à 3 buses sont disposées sous le dispositif de réception (10) et/ou dans l'anneau le plus inférieur.

14. Dispositif (22) selon la revendication 13, **caractérisé en ce que** pendant le nettoyage de la pile de substrats (2), la pile de substrats (2) est maintenue en particulier sur son pourtour avec 15 broches de fixation (7), de manière préférée avec 9 broches de fixation (7), de manière plus préférée avec 6 broches de fixation (7), de manière la plus préférée avec 3 broches de fixation (7).

15. Dispositif (22) selon l'une des revendications précédentes, présentant un bras, en particulier pouvant être rentré par pivotement, comprenant au moins une buse, qui est conçu pour le nettoyage de la face supérieure de la pile de substrats (2).

16. Procédé pour la dissolution au moins partielle d'une couche de liaison (4) d'une pile de substrats (2) collée de façon temporaire, comprenant les étapes suivantes, en particulier le déroulement suivant :
-- placement de la pile de substrats (2) à l'intérieur d'au moins un anneau (1) comprenant une pluralité de buses (1a), dans lequel les buses (1a) sont disposées en étant réparties au moins sur une partie du pourtour de l'au moins un anneau (1),
-- alignement des buses (1a) sur la couche de liaison (4),
-- pulvérisation de solvants sur un bord de la couche de liaison (4),
dans lequel plusieurs anneaux (1) sont disposés les uns sur les autres.
